# EUROPEAN PATENT SPECIFICATION

(11) **EP 0 589 092 B1**
(45) Date of publication and mention of the grant of the patent: **10.06.1998**
(21) Application number: 92202895.6
(22) Date of filing: 22.09.1992
(51) Int. Cl.: G01C 9/10, G01C 9/06, G01P 15/125

(54) **Inclination and acceleration sensor operating by means of capacitive detection of the position of a ball**
Neigungs- und Beschleunigungssensor unter Verwendung der kapazitiven Lagefeststellung einer Kugel
Capteur d'inclinaison et d'accélération actionné par la détection capacitive de la position d'une bille

(43) Date of publication of application: 30.03.1994
(73) Proprietor: SIGMA-DELTA N.V., B-3980 Tessenderlo (BE)
(72) Inventor:
(74) Representative: Stuart, Ian Alexander

(56) References cited:
- GB-A- 2 168 149
- US-A- 4 676 103
- PATENT ABSTRACTS OF JAPAN vol. 10, no. 47 (M-456) 25 February 1986; & JP-A-60 197 449

## Description

Electronic systems for detecting the inclination of an object tend to be expensive (e.g. using mercury wetted contacts) or unreliable (e.g. using a ball contact that works on a conductive contact).

JP-A-60/197,449 discloses an electronic sensor for capacitively detecting the effects of forces on an object, said sensor comprising a conductive ball and a substrate on which the ball can roll, said substrate having a form such that the ball is gravitationally biased to a central position; said substrate bearing printed conductive tracks such that the capacitance between pairs of said tracks is affected by the rolling of the ball. More specifically it discloses such a sensor in which the substrate is a circular resin body with a concave dish-like surface on which a mu-ltiplicity of concentric ring electrodes have been printed.

In contrast, the present invention provides such a sensor in which said substrate is a printed circuit board in which an elongate hole has been stamped, said hole having a wide central portion of width less than the diameter of the ball, and progressively narrowing elongate portions extending on either side of the central portion so that, when the circuit board is horizontally disposed, said gravitational biasing urges said ball to said wide central portion; and forces due to tilting or acceleration can progressively urge the ball to move along one of said narrowing elongate portions; and wherein said conductive tracks extend adjacent the edges of the hole.

A sensor embodying the invention can be both cheap and reliable. Since the detection is capacitive, the system does not need a conductive contact. Consequently, the system is insensitive to erosion, dust, etc. Also, since no pressure is required, it can be scaled to dimensions beneath one centimetre. All of these advantages add up to decrease the cost of the application, in which this system may be used.

Some embodiments of the invention will now be described with reference to the accompanying drawings in which:
Fig. 1 is a plan view of a printed circuit board (pcb) of a sensor embodying the invention;
Fig. 2 is a side view of the pcb of Fig. 1 in the region of the hole, also showing a ball in two different positions;
Fig. 3 is a block diagram of circuitry provided on a chip; and
Fig. 4 is a diagram for explaining the application of the invention to the measurement of acceleration.

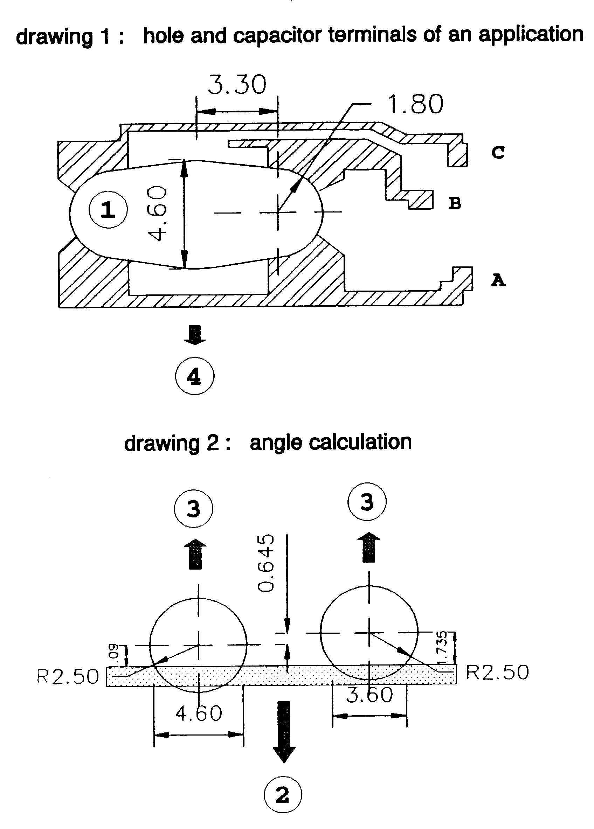

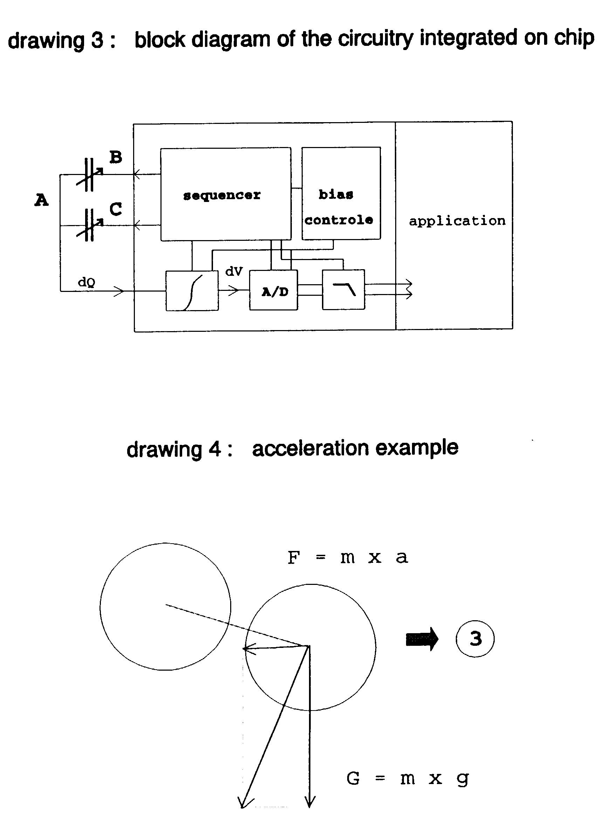

Figs. 1 and 2 show a pcb 2 in which an elongate hole 1 is stamped with well-controlled dimensions (see Fig. 1). A ball 3 is placed in that hole, so that it will roll forwards and backwards if the printed circuit board is tilted in the direction of elongation of the hole 1.

The ball 3 is conductive. Copper tracks 4 (A, B and C) are provided on the printed circuit board 2 at the edges of the hole. These are used as the plates of capacitors. We can define two capacitors (see Fig. 1):
- a capacitor between A and B
- a capacitor between A and C
These capacitors are series capacitors whose plates are two copper tracks with a (conductive) ball in between. If the ball rolls just between 2 copper tracks, the distance between the copper tracks and the ball will decrease, thus increasing their capacitance.

The circuitry provided on a chip (see Fig. 3) will now perform a measurement of the difference between these 2 capacitors.

The printed circuit board as represented in Fig. 1 is for use with a ball of 5mm diameter. (All dimensions on the drawings are expressed in millimetres.) The elongate hole 1 has a maximum width, in its centre, of 4.60mm. From here its width reduces in both directions.

Thus for a length of 3.30mm the sides converge, to an end region which is part-circular, of radius 1.80mm. As shown in Fig. 2, in the centre the ball is supported on sides 4.60mm apart, whereas at an end region it is supported on sides 3.60mm apart. Thus if the pcb 2 is horizontally as shown in Fig. 2, the ball rises by 0.645mm on rolling from the centre to an end. The ball can be caused to roll to the end by tilting the sensor.

The angle at which the ball rolls out of its middle position can be calculated. The inclination of the printed circuit board that enables the ball to roll horizontal is 11 degrees (the printed circuit board will then lower 0.645mm over a distance of 3.3mm).

If the printed circuit board is kept in a horizontal position, the ball will rest in the middle and the difference between the capacitors A/B and A/C will be lower than a predefined threshold.

If the printed circuit board is inclined by more than 11 degrees, the ball will roll to one side, creating a big difference between the capacitors, which will be detected by the chip (Fig. 3) . If the printed circuit board is inclined to the other side, the other capacitor will be dominant, which will also be detected by the chip.

The analog output of the sensor varies linearly with the position of the ball in an elongate portion of the hole. Thus one can shape the hole to get a continuous readout of the inclination (for example between -60 and +60 degrees). An elliptic form would be suitable for this purpose. In this case, one should take care to avoid hard contact between the copper tracks and the ball.

One may not only detect the effects of the gravity force that influences the position of the ball, but also other forces such as those due to accelerations. In this case, one should dimension the hole such that the acceleration force can counteract the effect of gravity and cause the ball to move from the central portion of the hole and roll along one of the elongate portions. Drawing 4 shows that the ball will start rolling if the acceleration is higher than a, given a mass m for the ball. A three-dimensional position sensing is also a possibility when using one conductive element (moving as the result of gravity) but multiple capacitor terminals.

## Claims

1. An electronic sensor for capacitively detecting the effects of forces on an object, said sensor comprising a conductive ball (3) and a substrate (2) on which the ball (3) can roll, said substrate having a form such that the ball (3) is gravitationally biased to a central position; said substrate (2) bearing printed conductive tracks (4) such that the capacitance between pairs of said tracks (4) is affected by the rolling of the ball; characterised in that said substrate (2) is a printed circuit board in which an elongate hole (1) has been stamped, said hole (1) having a wide central portion of width less than the diameter of the ball (3), and progressively narrowing elongate portions extending on either side of the central portion so that, when the circuit board (2) is horizontally disposed, said gravitational biasing urges said ball to said wide central portion; and forces due to tilting or acceleration can progressively urge the ball to move along one of said narrowing elongate portions; and wherein said conductive tracks extend adjacent the edges of the hole.

2. A sensor according to claim 1 wherein said tracks (4) provide a first capacitor (A,B) extending along the elongate portion of the hole on one side of the central portion and a second capacitor (A,C) extending along the elongate portion on the other side of the central portion; the arrangement being such that when the ball is in the central portion the difference between the capacitances of the two capacitors (A,B;A,C) is less than a threshold value whereas rolling of the ball into either elongate portion causes the capacitance of a respective one of the capacitors to exceed that of the other by a substantial amount.

3. A sensor according to claim 2 including circuitry coupled to the capacitors (A,B; A,C) for automatically comparing their capacitances and providing an output related to the difference; the hole (1) being shaped so that the output provides a continuous readout of the inclination of the printed circuit board.

4. An acceleration detector comprising a sensor according to claim 1 or claim 2 disposed so that the ball normally resides in the central portion but is urgeable along a side portion by forces due to acceleration.

## Patentansprüche

1. Elektronischer Sensor zum kapazitiven Detektieren der Auswirkungen von Kräften auf einen Gegenstand, wobei der Sensor eine leitende Kugel (3) und ein Substrat (2) umfasst, auf dem die Kugel (3) rollen kann, wobei das Substrat eine derartige Form aufweist, dass die Kugel (3) einem Schwerkraftdruck in Richtung zu einer Mittelposition unterworfen ist; wobei das Substrat (2) gedruckte leitende Spuren (4) aufweist, sodass die Kapazität zwischen Paaren der Spuren (4) durch das Rollen der Kugel beeinflusst wird; dadurch gekennzeichnet, dass das Substrat (2) eine Platine ist, in die ein längliches Loch (1) eingestanzt wurde, wobei das Loch (1) einen breiten Mittelabschnitt aufweist, dessen Breite geringer als der Durchmesser der Kugel (3) ist, und zunehmend schmäler werdende längliche Abschnitte an beiden Seiten des Mittelabschnitts verlaufen, sodass bei einer horizontalen Anordnung der Platine (2) der Schwerkraftdruck die Kugel zum breiten Mittelabschnitt drängt; und dass Kräfte aufgrund von Neigung oder Beschleunigung die Kugel zunehmend zur Bewegung entlang eines der schmäler werdenden länglichen Abschnitte drängen; und worin die leitenden Spuren angrenzend zu den Kanten des Lochs verlaufen.

2. Sensor nach Anspruch 1, worin die Spuren (4) einen ersten Kondensator (A, B), der sich entlang des länglichen Abschnitts des Lochs auf einer Seite des Mittelabschnitts erstreckt, und einen zweiten Kondensator (A, C), der sich entlang des länglichen Abschnitts auf der anderen Seite des Mittelabschnitts erstreckt, bilden; wobei die Anordnung solcherart ist, dass die Differenz zwischen den Kapazitäten der beiden Kondensatoren (A, B; A, C) unter einem Schwellenwert liegt, wenn sich die Kugel im Mittelabschnitt befindet, während das Rollen der Kugel in einen der länglichen Abschnitte bewirkt, dass die Kapazität eines jeweiligen Kondensators jene des anderen deutlich übersteigt.

3. Sensor nach Anspruch 2, umfassend Schaltungen, die an die Kondensatoren (A, B; A, C) gekoppelt sind, um ihre Kapazitäten automatisch zu vergleichen und ein mit der Differenz in Zusammenhang stehendes Ausgangssignal zu liefern; wobei das Loch (1) solcherart geformt ist, dass das Ausgangssignal ein kontinuierliches Auslesen der Neigung der Platine ermöglicht.

4. Beschleunigungsdetektor, umfassend einen Sensor nach Anspruch 1 oder 2, der solcherart angeordnet ist, dass sich die Kugel normalerweise im Mittelabschnitt befindet, jedoch durch Beschleunigungskräfte einen Seitenabschnitt entlang gedrängt werden kann.

## Revendications

1. Capteur électronique pour détecter capacitivement les effets de forces sur un objet, ledit capteur comprenant une bille conductrice (3) et un substrat (2) sur lequel la bille (3) peut rouler, ledit substrat ayant une forme telle que la bille (3) est sollicitée gravitationnellement à une position centrale; ledit substrat (2) portant des pistes conductrices imprimées (4) de sorte que la capacité entre des paires desdites pistes (4) est affectée par le roulement de la bille; caractérisé en ce que ledit substrat (2) est une plaque à circuit imprimé dans laquelle un trou allongé (1) a été matricé, ledit trou (1) ayant une portion centrale large de largeur inférieure au diamètre de la bille (3) et des portions allongées se rétrécissant progressivement s'étendant de chaque côté de la portion centrale de sorte que, lorsque la plaque de circuit (2) est disposée horizontalement, ladite sollicitation gravitationnelle sollicite ladite bille vers ladite portion centrale large; et des forces dûes à l'inclinaison ou l'accélération peuvent progressivement solliciter la bille pour se déplacer le long de l'une desdites portions allongées se rétrécissant; et où lesdites pistes conductrices s'étendent adjacentes aux bords du trou.

2. Capteur selon la revendication 1, dans lequel les pistes précitées (4) fournissent un premier condensateur (A, B) s'étendant le long de la portion allongée du trou sur un côté de la portion centrale et un second condensateur (A, C) s'étendant le long de la portion allongée sur l'autre côté de la portion centrale; l'agencement étant tel que, lorsque la bille est dans la portion centrale, la différence entre les capacités des deux condensateurs (A, B; A, C) est inférieure à une valeur de seuil, tandis que le roulement de la bille dans chaque portion allongée amène la capacité de l'un respectif des condensateurs à excéder celle de l'autre d'une quantité substantielle.

3. Capteur selon la revendication 2, comprenant un circuit couplé aux condensateurs (A, B; A,C) pour automatiquement comparer leurs capacités et fournir une sortie en rapport à la différence; le trou (1) étant conformé de sorte que la sortie fournit une lecture continue de l'inclinaison de la plaque à circuit imprimé.

4. Détecteur d'accélération comprenant un capteur selon la revendication 1 ou la revendication 2, disposé de sorte que la bille réside normalement dans la portion centrale mais peut être sollicitée le long d'une portion de côté par des forces dues à l'accélération.
